## Europäisches Patentamt

## European Patent Office

## Office européen des brevets

(11) Numéro de publication: **0 165 149**
**B1**

# (12) FASCICULE DE BREVET EUROPÉEN

(45) Date de publication du fascicule du brevet:
**18.05.88**

(21) Numéro de dépôt: **85400993.3**

(22) Date de dépôt: **21.05.85**

(51) Int. Cl.⁴: **H 01 R 13/658,** H 01 C 7/10,
H 01 R 13/719

(54) **Contact filtre et son utilisation dans les connecteurs électriques.**

(30) Priorité: **25.05.84 FR 8408251**

(43) Date de publication de la demande:
**18.12.85 Bulletin 85/51**

(45) Mention de la délivrance du brevet:
**18.05.88 Bulletin 88/20**

(84) Etats contractants désignés:
**DE FR GB**

(56) Documents cité:
**US-A-3 002 162**
**US-A-3 435 387**
**US-A-3 711 794**
**US-A-3 840 841**

**MACHINE DESIGN, vol. 52, no. 7, avril 1980, pages 135-136, Cleveland, Ohio, US; P. DOBROGOWSKI: "Filtering EMI with connectors"**

(73) Titulaire: **COMPAGNIE EUROPEENNE DE COMPOSANTS ELECTRONIQUES LCC, 50, rue Jean -Pierre Timbaud B.P. 301, F-92402 Courbevoie (FR)**

(72) Inventeur: **Turolla, Jean- Pierre, THOMSON- CSF SCPI 173, bld Haussmann, F-75379 Paris Cedex 08 (FR)**
Inventeur: **Belin, Simone, THOMSON- CSF SCPI 173, bld Haussmann, F-75379 Paris Cedex 08 (FR)**

(74) Mandataire: **Ruellan- Lemonnier, Brigitte, THOMSON- CSF SCPI 19, avenue de Messine, F-75008 Paris (FR)**

## Description

La présente invention concerne un contact filtre comportant un contact électrique sous forme d'une tige métallique, entouré par un élément filtre de forme tubulaire, muni d'une première électrode sur sa face externe et d'une seconde électrode sur sa face interne, cette seconde électrode étant électriquement reliée au contact électrique, les deux électrodes étant isolées l'une de l'autre.

De tels contacts filtres sont particulièrement utiles dans les connecteurs électriques. Un contact filtre de ce type est décrit dans le brevet français FR-A-2 185 879. Les contacts filtres décrits dans cette demande sont particulièrement destinés à l'atténuation des ondes de hautes fréquences. Le filtre utilisé est constitué par un élément tubulaire en céramique dans lequel·est logé un élément tubulaire en ferrite. On obtient ainsi un filtre de type LC ayant une fréquence de coupure dépendant de la valeur de ces éléments.

Si de tels éléments filtres permettent de supprimer les ondes HF susceptibles de moduler un signal analogique véhiculé par le contact électrique, ils sont généralement mal adaptés à la protection des signaux numériques contre les impulsions parasites d'origines diverses, présentant une forte surtension de manière aléatoire. De tels parasites sont susceptibles de modifier le contenu du message transmis sous forme numérique, ce qui peut engendrer des erreurs dans le signal reçu.

On connaît aussi par le brevet US-A-3 711 794 un élément filtre constitué par une varistance de forme toroïdale de faible épaisseur.

La présente invention permet d'éviter les inconvénients des contacts filtres de type LC et de perfectionner l'élément filtre décrit dans le brevet US-A-3 711 794. Dans ce but, le contact filtre selon l'invention est caractérisé en ce que la varistance présente une longueur supérieure à son épaisseur et en ce que sa seconde électrode se prolonge au moins sur l'une de ses faces latérales qui présente une zone arrondie de forme telle que l'enduction de la pâte d'électrode, connue en soi, dans cette zone, produit un dépôt d'épaisseur sensiblement constante.

Selon un mode préférentiel de réalisation, le contact filtre selon l'invention est caractérisé en ce que la seconde électrode est électriquement reliée au contact par un brasure, réalisée dans la zone de la face latérale de la varistance présentant une forme arrondie.

Dans son utilisation dans les connecteurs électriques, la première électrode d'un tel contact filtre, qui est disposée sur la face externe de la varistance, est reliée à la carrosserie métallique du connecteur et/ou à la masse.

L'invention sera mieux comprise à l'aide des exemples de réalisation suivants, donnés à titre non limitatif, conjointement avec les figures qui représentent:
- la figure 1, une vue en coupe d'un contact filtre selon l'invention;
- la figure 2, une vue en coupe partielle d'un connecteur électrique cylindrique muni d'un contact filtre selon l'invention.

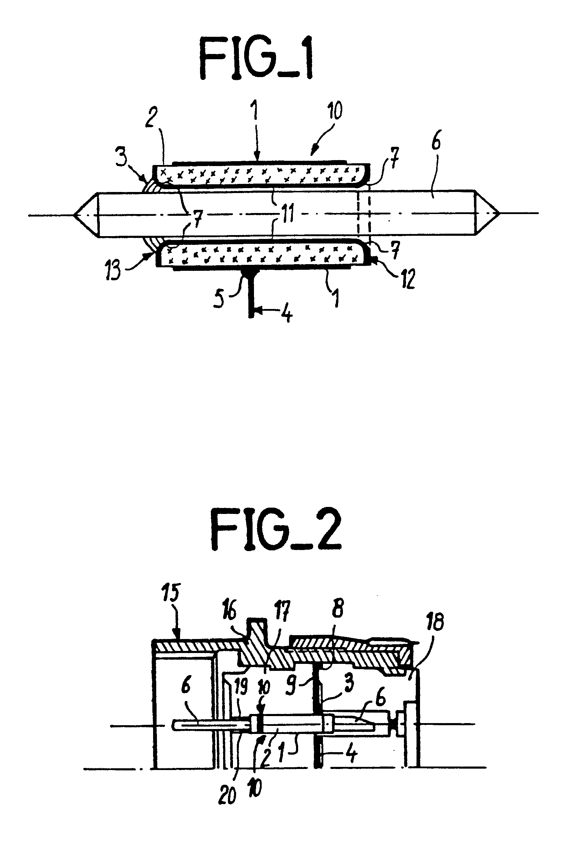

La figure 1 représente une vue en coupe d'un contact filtre selon l'invention. Ce contact filtre est essentiellement composé d'un contact électrique 6 et d'une varistance 10. Cette varistance 10 est de forme tubulaire et vient entourer le contact électrique 6. Cette varistance 10 comporte un corps 2 ayant une résistance non linéaire avec un seuil de tension $V_0$, bien connue sous l'appellation varistance. Ce corps 2 présente une longueur supérieure à son épaisseur comme représenté clairement sur la figure 2. Ce corps tubulaire 2 est entouré extérieurement d'une électrode cylindrique 1 et intérieurement d'une électrode également cylindrique 11. Cette électrode interne 11 se prolonge sur les faces latérales de la varistance tubulaire et recouvre complètement lesdites faces latérales, dans l'exemple représenté ci-dessus. Cette électrode interne 11 comporte une partie arrondie 7 qui suit la forme arrondie sensiblement identique des faces latérales du corps 2 de la varistance 10.

Selon une variante de réalisation, non représentée sur la figure, cette électrode interne 11 peut se poursuivre sur la face externe du tube formant la varistance 10. Sur cette face externe, bien entendu, les électrodes 1 et 11 seront disposées à une distance suffisante pour éviter tous risques de claquage éventuel entre les électrodes. La face latérale 13 de la varistance 10 est brasée sur le contact électrique 6. La brasure 3 réalise à la fois le contact électrique et le maintien mécanique entre la varistance et le contact électrique 6. Bien entendu, on peut également réaliser une brasure 3 sur la face latérale 12 de la varistance 10. En pratique, l'électrode externe 1 de la varistance est reliée par une brasure 5 à un plan de masse 4.

L'élément varistance proprement dit constituant le corps 2 de cette varistance 10 pourra être réalisé par exemple selon les indications données dans les brevets français FR-A-2 363 171 ou FR-A-2 475 791. En particulier, ce dernier précise l'épaisseur à donner à l'élément varistance suivant la tension de seuil $V_0$ à laquelle on désire voir basculer cet élément. En pratique, cet élément de varistance 10 sera réalisé à partir d'une composition à base d'oxyde de zinc $ZnO$ bien connue de l'homme de métier. Le procédé pour réaliser des varistances tubulaires consiste à filer une pâte, de la composition déterminée sur une broche de manière à obtenir un tube creux qui est tronçonné après séchage en éléments de longueur voulue puis fritté à la température appropriée. Après frittage, on dépose sur cet élément tubulaire les électrodes, sous forme d'une pâte pour sérigraphie, à base d'argent. Compte tenu de la forme tubulaire de ces varistances, le dépôt de l'électrode interne doit s'effectuer avec soin. En effet, si l'on veut pouvoir aisément souder avec un bon contact électrique cette électrode au contact 6, il est nécessaire que cette électrode interne 11 déborde légèrement ou complètement sur l'une au moins des faces latérales 12, 13 de la varistance tubulaire 10. Pour cela, on a constaté qu'il était nécessaire d'arrondir les bords internes de la varistance, de manière à supprimer tout angle au niveau de la transition entre la face interne du corps de la varistance 2 et les faces latérales 12 et 13. La forme exacte de l'arrondi à donner est déterminée en pratique par l'homme de métier par de simples manipulations de routine, en fonction de la nature de la pâte d'électrode utilisée ainsi que de la composition du corps de varistance 2. Cet arrondi aura une forme telle que, lors du dépôt de la pâte d'électrode, par enduction, on obtienne une électrode interne 11 d'épaisseur sensiblement constante entre la partie interne de la varistance jusqu'à l'extrémité au moins de la face latérale 12 et/ou 13.

Sur la figure 2, est représentée une vue en coupe partielle d'un connecteur utilisant un contact selon l'invention. Ce connecteur 15 comporte une carrosserie métallique 16 dans laquelle viennent se loger un bloc électrique 17 prolongé par un passe-fil en caoutchouc souple 18. Le contact électrique 6, muni de sa varistance 10, est introduit dans le logement correspondant 19 du bloc isolant 17. Ce contact électrique 6 vient s'appuyer par sa partie avant 20 contre une butée correspondante du bloc isolant 17. Après introduction des contacts électriques 6 munis de leur varistance 10, on vient coiffer l'ensemble par une plaque métallique 4 percée de trous de diamètre sensiblement égal, au jeu près, au diamètre extérieur de la varistance 10, puis on place des préformes de soudure 3 autour de chaque contact électrique 6 et une préforme de soudure 8 à l'extrémité de la plaque métallique 4. Par chauffage, on fond respectivement les préformes 3 et 8 fixant ainsi électriquement et mécanique ment d'une part l'électrode externe 1 de chaque varistance 10 à la plaque métallique 4, et d'autre part ladite plaque métallique 4 à la carrosserie métallique 16. D'autres modes de contact électrique entre l'électrode extérieure 1 de l'élément filtre et les moyens de mise à la masse sont par exemple décrits dans les brevets américains US-A-3 455 387, US-A-3 569 915 et dans le brevet français FR-A-2 141 962.

**Revendications**

1. Contact filtre comportant un contact électrique (6) sous forme d'une tige métallique, entouré par un élément filtre tubulaire (10) constitué par une varistance munie d'une première électrode (1) sur sa face externe et d'une seconde électrode (11) sur sa face interne, cette seconde électrode (11) étant électriquement reliée au contact électrique (6), les deux électrodes étant isolées l'une de l'autre, caractérisé en ce que la varistance (10) présente une longueur supérieure à son épaisseur et en ce que la seconde électrode (11) se prolonge au moins sur l'une de ses faces latérales (13) qui présente une zone arrondie (7) de forme telle que l'enduction de la pâte d'électrode, connue en soi, dans cette zone (7), produit un dépôt d'épaisseur sensiblement constante.

2. Contact filtre selon la revendication 1, caractérisé en ce que la seconde électrode (11) est électriquement reliée au contact (6) par une brasure (3), réalisée dans la zone (7) de la face latérale (13) de la varistance présentant une forme arrondie.

3. Contact filtre selon l'une des revendications 1 ou 2, caractérisé en ce que la seconde électrode (11) se prolonge également sur une partie de la face externe de la varistance (10).

4. Utilisation des contacts filtres selon l'une des revendications précédentes dans les connecteurs électriques.

**Patentansprüche**

1. Kontaktfilter mit einem elektrischen Kontakt (6) in Gestalt eines metallischen Stiftes, der von einem rohrförmigen Filterelement (10) umgeben ist, das aus einem Varistor besteht, welcher mit einer ersten Elektrode (1) auf seiner Außenseite und mit einer zweiten Elektrode (11) auf seiner Innenseite ausgestattet ist, wobei die zweite Elektrode (11) elektrisch mit dem Kontakt (6) verbunden ist und die beiden Elektroden gegeneinander isoliert sind, dadurch gekennzeichnet, daß der Varistor eine größere Länge als Dicke besitzt und daß sich die zweite Elektrode (11) zumindest über eine seiner Seitenflächen hinaus verlängert, welche eine abgerundete Zone (7) aufweist, derart, daß die an sich bekannte Verfüllung mit Elektrodenpaste in dieser Zone einen Belag von im wesentlichen konstanter Dicke ergibt.

2. Kontaktfilter nach Anspruch 1, dadurch gekennzeichnet, daß die zweite Elektrode (11) mit dem Kontakt (6) elektrisch durch eine Lötstelle (3) verbunden ist, welche in der Zone (7) der Seitenfläche (13) des eine abgerundete Form aufweisenden Varistors angebracht ist.

3. Kontaktfilter nach den Ansprüchen 1 oder 2, dadurch gekennzeichnet, daß sich die zweite Elektrode (11) auch über einen Teil der Außenfläche des Varistors (10) hinaus verlängert.

4. Verwendung des Kontaktfilters nach einem der vorausgehenden Ansprüche in elektrischen Verbindungseinheiten.

**Claims**

1. A contact filter comprising an electric contact (6) having the shape of a metallic pin, surrounded by a tubular filter element (10) constituted by a varistor provided with a first electrode (1) at its outer surface and a second electrode (11) at its inner surface, the second electrode being electrically connected to the electric contact (6) and both electrodes being isolated against each other, characterized in that the varistor (10) has a length superior to its thickness, and that the second electrode (11) extends at least over one of its lateral surfaces (13) which has a rounded zone (7) of such a shape that, the filling of the electrodes' paste, per se known, in this zone produces a deposit having an essentially constant thickness.

2. A contact filter according to claim 1, characterized in that the second electrode (11) is electrically connected to the contact (6) by intermediary of a brazing (3), realized within the zone (7) of the lateral surface (13) of the variator having a rounded shape.

3. A contact filter according to one of the claims 1 or 2, characterized in that the second electrode (11) extends also over a portion of the outer surface of the varistor (10).

4. The use of contact filters according to one of the preceeding claims in electrical connectors.

# FIG_1

# FIG_2